# EUROPEAN PATENT APPLICATION

(11) **EP 4 842 182 A1**
(43) Date of publication of application: **18.11.2026**
(21) Application number: 24916984.8
(22) Date of filing: 04.12.2024
(51) Int. Cl.: H10N 35/01, B21B 1/22, B23K 20/00, B23K 20/04, C21D 9/00, C22C 19/07, C22C 30/00, C22C 38/00, C22C 38/12, C22F 1/00, C22F 1/02, C22F 1/10, H01F 1/16, H10N 30/30, H10N 35/85

(54) **METHOD FOR PRODUCING MULTILAYER MATERIAL FOR MAGNETOSTRICTIVE VIBRATION POWER GENERATION**

(30) Priority: 10.01.2024 JP 2024001553
(71) Applicant: Tokushu Kinzoku Excel Co., Ltd., Toshima-ku Tokyo 1710031 (JP)
(72) Inventor: TSUKUTA, Kenji, Hiki-gun, Saitama 355-0342 (JP); MATSUOKA, Hidenori, Hiki-gun, Saitama 355-0342 (JP); SHIMASAKI, Makoto, Hiki-gun, Saitama 355-0342 (JP); HIRUTA, Shuhei, Hiki-gun, Saitama 355-0342 (JP); TAKAHASHI, Kazuma, Hiki-gun, Saitama 355-0342 (JP)
(74) Representative: Grünecker Patent- und Rechtsanwälte PartG mbB
(86) International application number: PCT/JP2024/042840
(87) International publication number: WO 2025/150299

(57) **Abstract**

Provided is a method for producing a clad material for magnetostrictive vibration power generation. Two types of metal strips of an Fe-Co-based alloy material having a hardness of 250 HV or less in surface hardness and a Ni material having a hardness of 140 HV or less in surface hardness are used as raw materials. The method includes: a roll bonding step of stacking two types of metal strips and performing a roll bonding treatment with a reduction ratio of 45 to 90%; and a diffusion heat treatment step of performing a diffusion heat treatment at 730 to 1400°C. Next, the method includes: a cold rolling step of performing cold rolling with a cumulative reduction ratio of 10 to 98%; and a finish heat treatment step of performing a finish heat treatment at a heating temperature of 730 to 1000°C, in this order, thereby obtaining a clad material having a two-layer structure. As a result, embrittlement of the Fe-Co-based alloy material is suppressed, and a clad material having excellent magnetostrictive performance and excellent bonding strength can be obtained with high productivity.

## Description

### Technical Field

The present invention relates to a method for producing a clad material having a two-layer clad structure used for magnetostrictive vibration power generation. Note that the term "magnetostrictive vibration power generation" as used herein refers to vibration power generation using an inverse magnetostrictive characteristic caused by vibration of a magnetostrictive material.

### Background Art

Magnetostrictive vibration power generation is a method of generating electricity by stress such as impact or vibration, using an energy conversion element capable of utilizing shape changes due to magnetization. Further, the above energy conversion element generates vibration when an alternating magnetic field is applied.

As a configuration of the energy conversion element, a two-layer clad structure is generally used in which a material that extends upon application of a magnetic field and a material that contracts upon application of a magnetic field are bonded. The material used for magnetostrictive vibration power generation is preferably a magnetic material having a large magnetostriction and a high saturation magnetic flux density.

Magnetostriction is a phenomenon in which dimensions of a magnetic material change when it is magnetized, and for an Fe-Co-based alloy material having a relatively large amount of change, saturation magnetostriction (λs/10⁻⁶) is about 70. For a Ni material, the saturation magnetostriction (λs/10⁻⁶) is about -40.

Further, the saturation magnetic flux density is a magnetic flux density when a magnetic material is magnetically saturated, and the larger the saturation magnetic flux density, the stronger a magnet. For example, an Fe50%-Co50% alloy material is an alloy material in which Co is added to Fe, which is a widely used magnetic material, in order to increase the saturation magnetic flux density, and is known as an alloy having a very strong magnetic force in which the number of Bohr magneton shows a peak on a Slater-Pauling curve.

For example, Patent Document 1 discloses an energy conversion member in which a magnetostrictive material and a soft magnetic material are bonded. The energy conversion member described in Patent Document 1 indicates that an Fe-Co-based alloy, an Fe-Al-based alloy, Ni, a Ni-Fe alloy, or a Ni-Co alloy is used as a magnetostrictive material, and the soft magnetic material has a holding force of 3 A/cm or less and is made of a magnetic material having a magnetostriction constant with a sign different from the magnetostriction constant of the magnetostrictive material. As a specific combination, an energy conversion member is exemplified in which one part is made of an Fe-Co alloy or an Fe-Al alloy having a positive magnetostriction constant and the other part is made of a Ni-0 to 20% by mass Febased alloy or a Ni-Co-based alloy having a negative magnetostriction constant.

And in the technique described in Patent Document 1, a solid magnetostrictive material and a solid soft magnetic material are bonded by thermal diffusion bonding, hot rolling, or hot drawing.

### Citation of Document

### Patent Document

Patent Document 1: International Publication WO 2018/230154 A

### Summary of Invention

### Technical Problem

However, Patent Document 1 does not describe specific conditions or the like regarding the bonding process described above.

For example, in an Fe-Co-based alloy, embrittlement may occur or magnetostrictive performance may be deteriorated depending on production conditions such as heat treatment conditions. Further, in an alloy having a body-centered cubic structure, since a magnetic domain wall is less likely to move due to stress, it is necessary to remove the stress generated during processing such as bonding by heat treatment or the like. For these reasons, it is important to produce a magnetic material or the like used for an energy conversion element under production conditions suitable for the material.

Further, in the technique described in Patent Document 1, sheet processing using a strip-shaped raw material is adopted during bonding, but this results in poor yield and inferior productivity, and is affected in terms of materials and parts, equipment and machinery, workers, work methods, and inspection and measurement for individual products. For this reason, it is necessary to thoroughly perform quality control for each product, and there is a risk that quality may vary depending on the control method.

In view of such circumstances, an object of the present invention is to provide a method for producing a clad material for magnetostrictive vibration power generation that has excellent productivity, little quality variation, and excellent vibration power generation characteristics.

### Solution to Problem

In order to achieve the above object, the present inventors have first conceived that a raw material (magnetic material) to be used is a coil-shaped metal strip from a viewpoint of improvement in productivity and further, quality control such as reduction in quality variation. Then, after examining various production conditions, the inventors have decided to stack two types of metal strips (Fe-Co-based alloy material and Ni material) and roll bond them to obtain a clad material having a two-layer clad structure. As a result, production can be performed under consistent production conditions, productivity is improved, and from the viewpoint of quality control, quality can be stably maintained, and quality inspections can be reduced. Further, by using a long metal strip wound in a coil shape as a raw material, it becomes easier to obtain a clad material having a uniform thickness ratio.

The present invention has been completed by further studies based on the above findings. The gist of the invention is as follows.
[1] A method for producing a clad material for magnetostrictive vibration power generation having a two-layer clad structure, in which
   two types of metal strips, an Fe-Co-based alloy material having a hardness of 250 HV or less in surface hardness and a Ni material having a hardness of 140 HV or less in surface hardness, are used as raw materials, and the method including in this order:
   a roll bonding step of stacking the two types of metal strips and performing a roll bonding treatment with a reduction ratio of 45 to 90% to obtain a clad material having a two-layer clad structure;
   a diffusion heat treatment step of performing a diffusion heat treatment at a heating temperature of 730 to 1400°C;
   a cold rolling step of performing cold rolling with a cumulative reduction ratio of 10 to 98%; and
   a finish heat treatment step of performing a finish heat treatment at a heating temperature of 730 to 1000°C.
[2] The method for producing a clad material for magnetostrictive vibration power generation according to [1], in which the clad material after cold rolling is a cold-rolled metal strip having a sheet thickness of 0.03 to 2.0 mm.
[3] The method for producing a clad material for magnetostrictive vibration power generation according to [1] or [2], in which the clad material after cold rolling contains an Fe-Co-based alloy layer with a thickness of 40 to 60% of the total sheet thickness.
[4] The method for producing a clad material for magnetostrictive vibration power generation according to any one of [1] to [3], in which the roll bonding treatment is performed in a processing temperature range of 20 to 720°C.
[5] The method for producing a clad material for magnetostrictive vibration power generation according to any one of [1] to [4], in which the diffusion heat treatment has a holding time of 1 to 30 minutes, and the finish heat treatment has a holding time of 2 hours or more.
[6] The method for producing a clad material for magnetostrictive vibration power generation according to any one of [1] to [5], in which the Fe-Co-based alloy material has a composition consisting of, in % by mass, Fe: 40 to 60% or further V: 1 to 5%, with a remainder of Co and inevitable impurities, and the Ni material has a composition consisting of, in % by mass, Ni: 99.5% or more, with a remainder of inevitable impurities.

### Advantageous Effects of Invention

According to the present invention, embrittlement of an Fe-Co-based alloy material is suppressed, and a clad material having excellent magnetostrictive performance and excellent bonding strength can be obtained industrially with high productivity, thereby providing a remarkable industrial effect as a clad material for vibration power generation.

### Brief Description of Drawings

Fig. 1 is an explanatory diagram illustrating production steps in the present invention.
Fig. 2 is an explanatory diagram schematically illustrating an outline of a roll bonding treatment.
Fig. 3 is an explanatory diagram schematically illustrating an outline of cold rolling.
Fig. 4 is an explanatory diagram schematically illustrating an outline of a power generation device used in examples.

### Description of Embodiments

The present invention is a method for producing a clad material having a two-layer clad structure, which is useful for magnetostrictive vibration power generation. The clad material obtained in the present invention has a two-layer clad structure of a Fe-Co-based alloy material and a Ni material.

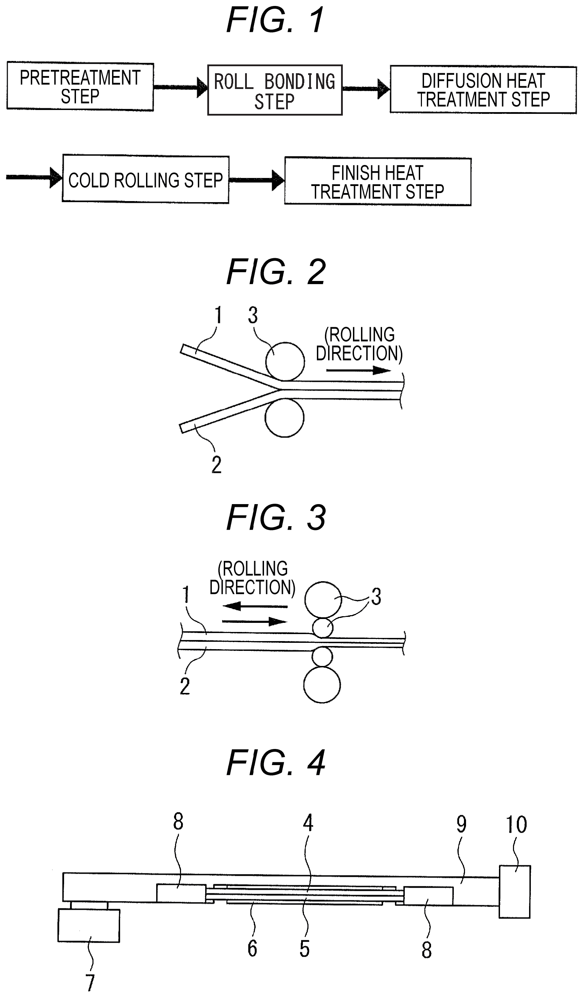

In the method for producing a clad material of the present invention, two types of metal strips of a Fe-Co-based alloy material and a Ni material are used as raw materials, and as illustrated in Fig. 1, the method preferably includes a pretreatment step, a roll bonding step, a diffusion heat treatment step, a cold rolling step, and a finish heat treatment step in this order to obtain a clad material (metal strip) having a two-layer clad structure. Each step will be described below.

### [Raw material]

In the present invention, two types of metal strips of an Fe-Co-based alloy material and a Ni material are used as raw materials.

Here, the Fe-Co-based alloy material has a composition consisting of, in % by mass, Fe: 40 to 60%, with the remainder of Co and inevitable impurities. Furthermore, a composition containing V: 1 to 5% may be used.

When the Fe-Co-based alloy material has a composition within the range described above, the saturation magnetostriction (λs/10⁻⁶) is as large as 50 to 70, and the saturation magnetic flux density also exhibits such a strong magnetic force that the number of Bohr magneton exceeds 2.25 on the Slater-Pauling curve. When an Fe-Co-based alloy material having such characteristics is used, an energy conversion element having high vibration power generation characteristics can be obtained. Note that when V within the range described above is further contained, cold workability is improved, and the magnetostriction and the saturation magnetic flux density can also be maintained at high levels.

Further, as the Ni material, it is preferable to use a material having a composition in which a content of Ni is 99.5% or more in % by mass, with the remainder of inevitable impurities. When the content of Ni is less than 99.5%, a softening temperature and work hardening characteristics change, which may affect uniformity of the thickness ratio after bonding. Note that in the Ni material having the composition described above, the saturation magnetostriction (λs/10⁻⁶) is -40, making a difference in magnetostriction from the Fe-Co-based alloy material very large.

The metal strip as a raw material needs to have a surface hardness of 250 HV or less in Vickers hardness for the Fe-Co-based alloy material and 140 HV or less in Vickers hardness for the Ni material. In a case where each hardness exceeds the hardness described above, bonding at a bonded interface is poor, and adhesion strength (also referred to as bonding strength) decreases. When bonding (roll bonding) in the roll bonding step, a softer raw material has better workability and allows for a larger reduction ratio per roll bonding operation, so that a degree of deformation at the bonded interface and the adhesion strength are improved. Further, bonding at this time is bonding between newly formed surfaces at the bonded interface, and an area of the newly formed surface increases as the reduction ratio increases, so that the adhesion strength is improved. Note that the surface hardness of the metal strip as a raw material is preferably adjusted by heating in an annealing furnace or the like.

Note that since the Fe-Co-based alloy material as a raw material has higher surface hardness (deformation resistance) than the Ni material to be combined, when a clad material is produced by roll bonding or the like using a metal strip (raw material) having the same thickness as the Ni material, the thickness of the Ni material becomes thinner due to the difference in deformation resistance. Therefore, it is necessary to appropriately adjust a raw material thickness of the Fe-Co-based alloy material and the Ni material according to the difference in surface hardness (deformation resistance) of the raw materials. In the present invention, the raw material thickness of the Fe-Co-based alloy material is preferably 85 to 95% of the raw material thickness of the Ni material. As a result, the thickness of the Fe-Co-based alloy layer in the clad material, which is a product, can be 40 to 60% of the total thickness of the clad material. Note that a ratio is preferably 45 to 55%. By bringing the thickness of the Fe-Co-based alloy layer closer to 50% of the total thickness of the clad material, cancellation of a magnetostrictive effect and an inverse magnetostrictive effect is eliminated.

Note that instead of the Fe-Co-based alloy material, an Fe-Ni-based alloy material or an Fe-Al-based alloy material, which are also magnetic materials, may be used. Although these alloy materials are inferior in saturation magnetostriction and saturation magnetic flux density to the Fe-Co-based alloy material, they can be used as clad materials for magnetostrictive vibration power generation by applying the production method of the present invention.

Further, instead of the Ni material having the composition described above, examples of a material that can similarly maintain vibration power generation characteristics in combination with an Fe-Co-based alloy material include a Ni-Co-based alloy material and a soft magnetic material (Fe material) such as SPCC. By combining a Ni-Co-based alloy material or an Fe material with an Fe-Co-based alloy material and applying the production method of the present invention, it is possible to produce a clad material for magnetostrictive vibration power generation that is inferior in characteristics to the combination of an Fe-Co-based alloy material and a Ni material but can similarly maintain vibration power generation characteristics. Note that it is preferable that the surface hardness of the Fe-Co-based alloy material, the Fe-Ni-based alloy material, and the Fe-Al-based alloy material used as a raw material is 250 HV or less in Vickers hardness, and the surface hardness of the Ni material, the Ni-Co-based alloy material, and the soft magnetic material (Fe material) is 140 HV or less in Vickers hardness.

### [Pretreatment step]

First, in order to facilitate roll bonding of the two types of raw materials, it is preferable to perform a treatment for activating an entire surface of the Fe-Co-based alloy material and the Ni material as raw materials, before the roll bonding step. The treatment for activating the surface is preferably a brushing treatment. The brushing treatment is a treatment of polishing the surface of a raw material with a brush. Note that a chemical treatment such as pickling, a mechanical treatment such as polishing or grinding using a grinder or blasting, or ion etching may be applied as long as it is a treatment for activating the surface. Note that a surface roughness after the activation treatment, measured as an arithmetic average roughness Ra, is preferably twice or more than that before the activation treatment, with Ra: 0.1 µm or more and 3.0 µm or less for the Fe-Co-based alloy material, and Ra: 0.1 µm or more and 4.0 µm or less for the Ni material. Here, the surface roughness shall be measured in accordance with the provisions of JIS B 0601.

### [Roll bonding step]

In the roll bonding step, two types of raw materials (Fe-Co-based alloy material and Ni material) subjected to the surface activation treatment are stacked, and a roll bonding treatment with a reduction ratio of 45 to 90% is performed, and the materials are mechanically and physically brought into close contact (pressure bonded) to form a clad material having a two-layer clad structure. Note that in the roll bonding treatment, as illustrated in Fig. 2, a method is used in which metal strips 1 and 2 are stacked and pressure bonded by rolling using a roll 3.

When the reduction ratio is less than 45%, bonding (roll bonding) is not sufficiently performed. When the reduction ratio exceeds 90%, edge cracking occurs during roll bonding, making roll bonding difficult. Here, edge cracking refers to cracks that occur on the surface of a sheet material near an edge end in a sheet width direction of the sheet material to be pressure bonded. For this reason, the reduction ratio in the roll bonding treatment was set to a range of 45 to 90%. Further, it is preferable that the roll bonding treatment is performed once.

The type of cold rolling mill used in the roll bonding treatment is not particularly limited, and any conventional rolling mill such as a two-stage rolling mill or a four-stage rolling mill can be applied, but it is preferable to use a multi-stage rolling mill, which is a rolling mill having a uniform rolling reduction force distribution in the sheet width direction and a uniform sheet thickness profile.

Further, the roll bonding treatment is performed in a processing temperature range of 20 to 720°C. When the temperature is lower than 20°C, it is difficult to produce at a temperature lower than the temperature in consideration of heat generation due to plastic working. Further, when the temperature exceeds 720°C, there is a risk of significant embrittlement due to ordering of α' phase. Therefore, it is preferable to adjust the temperature within the temperature range described above by a temperature controller during the roll bonding treatment at warm temperatures.

An order-disorder transformation point of α phase of a body-centered cubic lattice in the Fe-Co-based alloy material exists near 730°C, and the Fe-Co-based alloy material becomes a mixed phase of the ordered α' phase of the body-centered cubic lattice and γ phase of a facecentered cubic lattice in a temperature range of 700°C or lower. In particular, when a cooling rate from near the transformation point of 730°C is slow, an embrittlement phenomenon is observed due to the ordered α' phase.

Note that in a case where the treatment for activating the surface is performed as a pretreatment step, the roll bonding treatment is preferably performed within 12 hours after the pretreatment step. When the roll bonding treatment is performed after 12 hours have elapsed, the bonding strength at the bonded interface in the obtained clad material may decrease.

Further, a clad material (also referred to as a clad material after the roll bonding treatment), which is a metal strip having a two-layer structure bonded (pressure bonded) in the roll bonding step is usually wound up by a winding machine (not illustrated).

### [Diffusion heat treatment step]

The clad material obtained through the roll bonding step (also referred to as a clad material after the roll bonding treatment) is subjected to diffusion heat treatment for the purpose of mutual diffusion of metal atoms at the bonded interface of the clad material. The diffusion heat treatment is a treatment of heating in the temperature range of 730 to 1400°C.

When the heating temperature is below 730°C, mutual diffusion at the bonded interface of the clad material is unlikely to occur, and sufficient bonding strength may not be obtained. On the other hand, when the heating temperature exceeds 1400°C, since a melting point of nickel is 1453°C, there is a risk of melting.

Further, the holding time of the diffusion heat treatment is preferably in the range of 1 to 30 minutes. When the holding time is less than 1 minute, mutual diffusion at the bonded interface of the clad material is unlikely to occur, and sufficient bonding strength cannot be obtained. On the other hand, when the holding time exceeds 30 minutes, productivity decreases significantly.

By the diffusion heat treatment as described above, the bonded interface is firmly bonded, and the bonding strength of the clad material is improved. The bonding at the bonded interface after mutual diffusion of metal atoms is very strong, and no peeling of a bonding portion has been confirmed even in a 90-degree repeated bending test.

The diffusion heat treatment as described above is preferably performed using a continuous heat treatment furnace. Note that in a case where a continuous heat treatment furnace is used, the maximum thickness of the material to be heat-treated (clad material after the roll bonding treatment) is preferably 5.0 mm or less. When the maximum thickness exceeds 5.0 mm, it becomes impossible to complete the heat treatment within 30 minutes.

Note that in order to prevent embrittlement due to the ordered α' phase from near the transformation point of 730°C in the Fe-Co-based alloy material, it is necessary to increase the cooling rate after the diffusion heat treatment, and the cooling rate is preferably 300°C/min or more. Further, the diffusion heat treatment is preferably performed in an inert gas atmosphere such as Ar or N or a reducing atmosphere of hydrogen gas.

### [Cold rolling step]

In the cold rolling step, the clad material (pressurebonded clad material) that has undergone the diffusion heat treatment is cold-rolled while still in the state of a metal strip, with a reduction ratio selected so that the cumulative reduction ratio becomes 1 to 98%, to obtain a clad material (clad material after cold rolling) having a predetermined product sheet thickness.

When the cumulative reduction ratio is less than 1%, the force of front and rear tensions of the winding machine acts more strongly than the rolling force, causing the material to be rolled to slip and making cold rolling difficult. Further, when the cumulative reduction ratio exceeds 98%, a rolling limit is reached due to work hardening of the material to be rolled, and it becomes necessary to add a softening heat treatment, which decreases productivity. Note that in consideration of productivity, the cumulative reduction ratio is preferably 5 to 90%. The cumulative reduction ratio referred to herein can be calculated by the following formula. 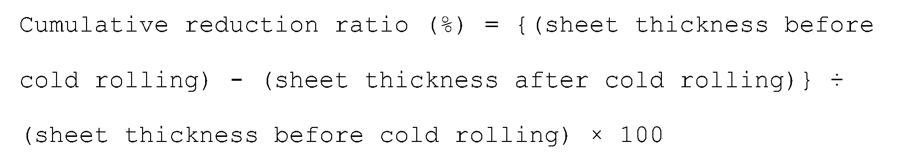 Cumulative reduction ratio (%) = {(sheet thickness before cold rolling) - (sheet thickness after cold rolling)} ÷ (sheet thickness before cold rolling) × 100

The cold rolling is repeated rolling in which rolling is performed a plurality of times. The number of repetitions is preferably 5 to 10 times. Further, the material is wound into a coil shape by a coil winding machine (not illustrated) for each rolling, but in a case where the number of times of rolling is large, it is preferable to adopt a reverse type in which winding is possible not only in one direction but also in the opposite direction. Note that as a rolling mill used for cold rolling, a conventional two-stage rolling mill or four-stage rolling mill, and a multi-stage rolling mill such as a Sendzimir mill or a Loan rolling mill are all suitable, but it is preferable to select, for example, a multi-stage rolling mill, which is a rolling mill having a uniform rolling reduction force distribution in the sheet width direction and a uniform sheet thickness profile. This is because, after the finish heat treatment step, which is the final step, slitting (not illustrated) may be performed as necessary, and the product may be shipped after being divided and cut in the width direction. Fig. 3 shows an outline of cold rolling using a four-stage rolling mill.

Note that during cold rolling, the material to be rolled is cooled with rolling oil, but heat generation due to plastic working cannot be avoided, and therefore cold rolling is preferably performed in a processing temperature range of room temperature to 200°C. The temperature range is more preferably room temperature to 100°C.

Further, the sheet thickness of the clad material after cold rolling is preferably 0.03 to 2.0 mm, which is a predetermined product sheet thickness. When the sheet thickness is less than 0.03 mm, flatness is deteriorated, and shape correction by a tension leveler also becomes difficult. From a viewpoint of vibration power generation characteristics, the flatness is preferably such that warpage or waviness is 1 mm or less over an area of 100 mm². The flatness is measured on a surface plate using a thickness gauge or a dial gauge. When the sheet thickness of the cold-rolled clad material exceeds 2.0 mm, the holding time in the diffusion heat treatment step exceeds 30 minutes, and therefore productivity decreases.

In the clad material after cold rolling, the thickness of the Fe-Co-based alloy layer in the clad material is 40 to 60% of the total thickness. When the thickness of the Fe-Co-based alloy layer is less than 40% or more than 60% of the total thickness, cancellation of the magnetostrictive effect/inverse magnetostrictive effect of the Fe-Co-based alloy material and the Ni material occurs, resulting in a decrease in vibration power generation characteristics. Note that the thickness of the Fe-Co-based alloy layer is preferably 45 to 55% of the total thickness. Such a thickness of the Fe-Co-based alloy layer in the clad material after cold rolling can be achieved by adjusting the thickness of each raw material.

### [Finish heat treatment step]

In the finish heat treatment step, the clad material described above (clad material after cold rolling) is subjected to a finish heat treatment at a heating temperature of 730 to 1000°C to obtain a product.

When the heating temperature is below 730°C, the stress in the Fe-Co-based alloy material cannot be removed. In an alloy having a BCC structure, the magnetic domain wall is less likely to move due to residual stress, and thus the vibration power generation characteristics are deteriorated. Further, when the heating temperature exceeds 1000°C, the γ phase starts to precipitate, the function as a magnetic material decreases, and the magnetostriction and the saturation magnetic flux density also decrease. Note that the heating temperature is preferably 900°C or lower. Note that in a case where an Fe-Ni-based alloy material or an Fe-Al-based alloy material is used as the raw material, the heating temperature is preferably 370 to 1200°C for the Fe-Ni-based alloy material and 700 to 1200°C for the Fe-Al-based alloy material.

Note that since the heat treatment furnace used for the finish heat treatment needs to be cooled slowly after the finish heat treatment, it is preferable to use a batch-type heat treatment furnace. The finish heat treatment step is the final step, and it is important to increase the magnetostriction without considering embrittlement. The α' phase of the Fe-Co-based alloy material becomes brittle due to ordering, but its saturation magnetostriction (λs/10⁻⁶) is 70, which is higher than that of the α phase and the γ phase. Therefore, it is appropriate to set the structure after the finish heat treatment to the α' phase. Therefore, it is preferable that the cooling after the finish heat treatment is slow cooling, and the cooling rate is 300°C/hour or less.

Further, the holding time of the finish heat treatment is preferably 2 hours or more. When the holding time is less than 2 hours, the α phase cannot be sufficiently precipitated in the heating temperature range of 730 to 1000°C, and after cooling, a mixed phase of the α' phase and the γ phase is formed, so that the magnetostriction becomes small. Note that the atmosphere for the finish heat treatment is preferably a reducing atmosphere of hydrogen gas. During cooling, an inert gas atmosphere such as Ar or N is preferable.

The clad material produced by the production method including the steps described above, as an energy conversion member, can enhance power generation efficiency of vibration power generation using the inverse magnetostrictive characteristic. For example, in a case where the clad material according to the present invention is used as a double-supported beam and vibrated in a double-supported manner, tensile and compressive deformation repeatedly occur in the Fe-Co-based alloy layer and the Ni layer, generating electricity. Moreover, since a voltage direction is always the same in both layers, high power generation efficiency can be achieved. Further, when the clad material of the present invention is used, vibration efficiency of a vibration part utilizing the magnetostrictive characteristic can also be enhanced.

Hereinafter, the present invention will be further described based on examples.

### Examples

Fe-Co-based alloy materials (types: F1 to F9) having the composition shown in Table 1 and Ni materials (types: N1 to N3) having the composition shown in Table 2 were prepared as raw materials. The shape of the raw material was a coil-shaped metal strip (unit weight: 1.0 kg) for both the Fe-Co-based alloy material and the Ni material, and dimensions were 0.2 to 4.8 mm in sheet thickness × 40 to 150 mm in width × 20 to 100 m in length.

The hardness of the Fe-Co-based alloy material and the Ni material prepared as raw materials was varied in various ways by annealing treatment as shown in Table 3. Further, depending on the hardness of the Ni material, the thickness of the Fe-Co-based alloy material was adjusted by cold rolling so as to be in the range of 85 to 95% of the thickness of the Ni material. Note that some cases were prepared where the thickness of the Fe-Co-based alloy material fell outside the range of 85 to 95% of the thickness of the Ni material. Further, as a pretreatment step, a surface activation treatment for brushing the entire surface of the metal strip as a raw material was performed. After the activation treatment, the surface roughness Ra measured according to JIS B 0601 was Ra: 0.1 to 3.0 µm for the Fe-Co-based alloy material and Ra: 0.1 to 4.0 µm for the Ni material.

Two types of raw materials (metal strips) having undergone the hardness adjustment and thickness adjustment as described above were combined as shown in Table 3, and a clad material having a two-layer structure was produced by a production method including a roll bonding step, a diffusion heat treatment step, a cold rolling step, and a finish heat treatment step in this order.

### [Roll bonding step]

Two types of raw materials (Fe-Co-based alloy material and Ni material) were stacked, and a single roll bonding treatment was performed at the temperature and reduction ratio shown in Table 3 in the state of metal strips using a multi-stage rolling mill, to pressure-bond the two types of raw materials and obtain a clad material having a two-layer structure. After the roll bonding treatment, the material was wound into a coil shape using a winding machine. In a case where the material was not pressure bonded, the subsequent treatment was stopped. Note that in Table 3, the sheet thickness of the clad material obtained by the roll bonding treatment is also shown.

### [Diffusion heat treatment step]

The obtained clad material after the roll bonding treatment was subjected to a diffusion heat treatment at the temperature and holding time shown in Table 3 using a continuous heat treatment furnace. The diffusion heat treatment was performed in a hydrogen gas atmosphere. Note that after the diffusion heat treatment, cooling by indirect water cooling was performed. The cooling rate was in the range of 300 to 350°C/min.

Further, the bonding strength was evaluated using the clad material after the diffusion heat treatment as a test piece. The bonding strength was evaluated by a bending test in accordance with the provisions of JIS Z 2248. The bending test was performed by 90° bending using a pressing tool (tip radius R: 0.4 mm). Bending was repeatedly performed until fracture, and the bending fracture surface was observed with a stereomicroscope (×20). A case where the fracture surface was not peeled off at a bonded portion was evaluated as "○", and a case where the fracture surface was peeled off (fractured) at the bonded portion was evaluated as "×". The obtained results are also shown in Table 3. Note that those evaluated as "×" were not subjected to subsequent treatment.

### [Cold rolling step]

The clad material after the diffusion heat treatment was repeatedly subjected to cold rolling at the temperature and cumulative reduction ratio shown in Table 3 using a multi-stage rolling mill to obtain a clad material (clad material after cold rolling) having a predetermined product sheet thickness. After cold rolling, the material was wound into a coil shape using a winding machine. The sheet thickness of the obtained clad material is also shown in Table 3.

Further, when the clad material after the diffusion heat treatment was cold rolled, presence or absence of fracture during a first cold rolling was observed. Embrittlement of the clad material (clad material after diffusion heat treatment) was evaluated with a case where fracture occurred during the first cold rolling as "×" and a case where no fracture occurred as "○". The obtained results are also shown in Table 3. Note that those fractured during cold rolling were not subjected to subsequent treatment.

### [Finish heat treatment step]

The obtained clad material after cold rolling was subjected to a finish heat treatment at the heating temperature and holding time shown in Table 3 using a batch type heat treatment furnace to obtain a product (clad material). The finish heat treatment was performed in a reducing atmosphere of hydrogen gas. Note that after the finish heat treatment, the material was slowly cooled. The cooling rate was within the range of 250 to 300°C/hr.

For the obtained product (clad material), a power generation amount (mW) was measured using a power generation device shown in Fig. 4. The obtained power generation amount (mW) was compared with the power generation amount (mW) in a case of using a single material of Fe-Co-based alloy (type: 60Fe5VCo) to evaluate power generation vibration characteristics. A case where the power generation amount was three times or more of that in the case of using a single material of Fe-Co-based alloy was evaluated as ○, and a case where the power generation amount was less than three times of that in the case of using a single material of Fe-Co-based alloy was evaluated as ×.

As illustrated in Fig. 4, the power generating device includes a yoke 9, a permanent magnet 8, a power generation coil 6, a vibration source 7, and a weight 10. The clad material (two-layer structure consisting of an Fe-Co-based alloy layer 5 and a Ni layer 4) as a measurement piece had a thickness equal to the product sheet thickness, a width of 5 mm and a length of 50 mm. A weight of the weight was adjusted so that a resonance frequency was approximately 70 Hz.

Further, for the obtained product (clad material), a cross section in the sheet thickness direction was polished and imaged using an optical microscope (magnification: 100×), the thickness of each layer (Fe-Co-based alloy layer 5 and Ni layer 4) was measured, and a thickness ratio of each layer was calculated. The obtained results are also shown in Table 3.

**[Table 1]**

| Fe-Co-based alloy material | Chemical composition (% by mass) | | |
|---|---|---|---|
| Type | Fe | V | Remainder |
| F1 | 40.00 | - | Co |
| F2 | 50.00 | - | Co |
| F3 | 60.00 | - | Co |
| F4 | 40.00 | 1.00 | Co |
| F5 | 50.00 | 1.00 | Co |
| F6 | 60.00 | 1.00 | Co |
| F7 | 40.00 | 5.00 | Co |
| F8 | 50.00 | 5.00 | Co |
| F9 | 60.00 | 5.00 | Co |

**[Table 2]**

| Ni material | Chemical composition (% by mass) | |
|---|---|---|
| Type | Ni | Remainder |
| N1 | 99.50 | Inevitable impurities |
| N2 | 99.60 | Inevitable impurities |
| N3 | 99.80 | Inevitable impurities |

**[Table 3]**

| Clad material No. | Combination of raw materials | | Surface hardness of raw material (HV) | | Roll bonding treatment | | | Diffusion heat treatment | | | Cold rolling | | | | Finish heat treatment | | Thickness ratio of each layer of clad material (%) | | Vibration power generation characteristic | Remarks |
|---|---|---|---|---|---|---|---|---|---|---|---|---|---|---|---|---|---|---|---|---|
| | Fe-Co-based alloy material | Ni material | Fe-Co-based alloy material | Ni material | Processing temperature (°C) | Reduction ratio (%) | Sheet thickness (mm) | Heating temperature (°C) | Time (Min) | Bonding strength | Rolling temperature (°C) | Cumulative reduction ratio (%) | Sheet thickness (mm) | Embrittlement | Heating temperature (°C) | Time (H) | Fe-Co-based alloy layer | Ni layer | | |
| 1 | F1 | N3 | 203 | 93 | 710 | 60 | 1.301 | 800 | 2 | ○ | 190 | 2 | 1.275 | ○ | 800 | 3.0 | 49 | 51 | ○ | Invention example |
| 2 | F5 | N2 | 209 | 110 | 680 | 70 | 0.502 | 850 | 1 | ○ | 90 | 70 | 0.151 | ○ | 750 | 2.0 | 55 | 45 | ○ | Invention example |
| 3 | F9 | N2 | 223 | 111 | 100 | 78 | 2.113 | 1100 | 3 | ○ | Room temperature | 98 | 0.042 | ○ | 990 | 3.5 | 43 | 57 | ○ | Invention example |
| 4 | F2 | N3 | 248 | 138 | 250 | 55 | 2.305 | 750 | 10 | ○ | 70 | 83 | 0.392 | ○ | 1000 | 4.0 | 50 | 50 | ○ | Invention example |
| 5 | F3 | N1 | 231 | 125 | 450 | 85 | 1.210 | 900 | 9 | ○ | Room temperature | 1 | 1.198 | ○ | 830 | 2.5 | 60 | 40 | ○ | Invention example |
| 6 | F8 | N2 | 215 | 122 | 560 | 65 | 0.530 | 1200 | 20 | ○ | 150 | 83 | 0.090 | ○ | 770 | 3.0 | 59 | 41 | ○ | Invention example |
| 7 | F6 | N3 | 211 | 109 | 340 | 50 | 3.021 | 950 | 1 | ○ | Room temperature | 50 | 1.511 | ○ | 950 | 4.5 | 47 | 53 | ○ | Invention example |
| 8 | F5 | N1 | 235 | 136 | 90 | 49 | 1.030 | 1350 | 5 | ○ | Room temperature | 86 | 0.144 | ○ | 780 | 3.0 | 53 | 47 | ○ | Invention example |
| 9 | F4 | N3 | 250 | 99 | 50 | 89 | 0.043 | 730 | 30 | ○ | Room temperature | 30 | 0.030 | ○ | 810 | 2.0 | 40 | 60 | ○ | Invention example |
| 10 | F7 | N2 | 207 | 117 | 30 | 88 | 0.333 | 830 | 9 | ○ | Room temperature | 87 | 0.043 | ○ | 950 | 4.0 | 51 | 49 | ○ | Invention example |
| 11 | F9 | N2 | 216 | 133 | 20 | 48 | 3.502 | 780 | 10 | ○ | Room temperature | 44 | 1.961 | ○ | 900 | 2.5 | 60 | 40 | ○ | Invention example |
| 12 | F1 | N3 | 243 | 140 | 720 | 50 | 0.501 | 990 | 2 | ○ | Room temperature | 87 | 0.065 | ○ | 960 | 4.0 | 53 | 47 | ○ | Invention example |
| 13 | F3 | N3 | 245 | 98 | 300 | 55 | 0.433 | 1050 | 15 | ○ | 100 | 68 | 0.139 | ○ | 740 | 3.0 | 46 | 54 | ○ | Invention example |
| 14 | F2 | N1 | 213 | 114 | 270 | 88 | 0.135 | 1330 | 8 | ○ | Room temperature | 21 | 0.107 | ○ | 840 | 3.5 | 52 | 48 | ○ | Invention example |
| 15 | F4 | N3 | 229 | 129 | 420 | 85 | 0.803 | 1280 | 29 | ○ | Room temperature | 36 | 0.514 | ○ | 950 | 2.0 | 58 | 42 | ○ | Invention example |
| 16 | F6 | N2 | 238 | 93 | 590 | 75 | 0.944 | 780 | 4 | ○ | Room temperature | 45 | 0.519 | ○ | 890 | 4.5 | 41 | 59 | ○ | Invention example |
| 17 | F5 | N1 | 205 | 131 | 710 | 61 | 0.354 | 830 | 22 | ○ | Room temperature | 55 | 0.159 | ○ | 760 | 3.5 | 46 | 54 | ○ | Invention example |
| 18 | F7 | N3 | 203 | 136 | 720 | 50 | 4.031 | 1000 | 8 | ○ | 170 | 76 | 0.967 | ○ | 1000 | 2.0 | 53 | 47 | ○ | Invention example |
| 19 | F9 | N1 | 244 | 125 | 600 | 55 | 3.033 | 1390 | 16 | ○ | Room temperature | 80 | 0.607 | ○ | 880 | 2.5 | 59 | 41 | ○ | Invention example |
| 20 | F1 | N1 | 236 | 128 | 150 | 47 | 1.643 | 1170 | 6 | ○ | 195 | 5 | 1.561 | ○ | 730 | 2.0 | 47 | 53 | ○ | Invention example |
| 21 | F7 | N2 | 215 | 110 | 280 | 63 | 0.314 | 1230 | 23 | ○ | Room temperature | 13 | 0.273 | ○ | 830 | 3.0 | 52 | 48 | ○ | Invention example |
| 22 | F6 | N3 | 211 | 107 | 330 | 50 | 0.613 | 1350 | 6 | ○ | Room temperature | 95 | 0.031 | ○ | 940 | 4.5 | 49 | 51 | ○ | Invention example |
| 23 | F3 | N1 | 222 | 118 | 120 | 65 | 0.314 | 1000 | 14 | ○ | 180 | 9 | 0.286 | ○ | 870 | 3.0 | 56 | 44 | ○ | Invention example |
| 24 | F2 | N2 | 250 | 140 | 70 | 45 | 5.000 | 880 | 9 | ○ | Room temperature | 77 | 1.150 | ○ | 900 | 3.0 | 44 | 56 | ○ | Invention example |
| 25 | F2 | N3 | 240 | 145 | 100 | 50 | Not bonded | - | - | - | - | - | - | - | - | - | - | - | - | Comparative example |
| 26 | F5 | N2 | 255 | 135 | 700 | 60 | Not bonded | - | - | - | - | - | - | - | - | - | | - | - | Comparative example |
| 27 | F3 | N1 | 210 | 101 | 440 | 42 | Not bonded | - | - | - | - | - | - | - | - | - | - | - | - | Comparative example |
| 28 | F9 | N2 | 234 | 116 | 728 | 87 | 1.031 | 790 | 20 | ○ | 100 | 1 | 1.021 | × | - | - | - | - | - | Comparative example |
| 29 | F8 | N3 | 225 | 95 | 610 | 45 | 0.510 | 720 | 10 | × | - | - | - | - | - | | - | - | - | Comparative example |
| 30 | F7 | N3 | 230 | 110 | 700 | 50 | 0.355 | 1000 | 0.8 | × | - | - | - | - | - | | - | - | - | Comparative example |
| 31 | F4 | N1 | 240 | 125 | 100 | 66 | 0.911 | 750 | 28 | ○ | 110 | 55 | 0.410 | ○ | 725 | 3.0 | 45 | 55 | × | Comparative example |
| 32 | F6 | N2 | 205 | 106 | 35 | 45 | 0.543 | 810 | 30 | ○ | Room temperature | 9 | 0.494 | ○ | 800 | 1.5 | 53 | 47 | × | Comparativ e example |
| 33 | F1 | N1 | 243 | 99 | 710 | 89 | 0.213 | 730 | 1 | ○ | 50 | 41 | 0.126 | ○ | 810 | 2.0 | 38 | 62 | × | Comparative example |
| 34 | F3 | N2 | 230 | 100 | 600 | 51 | 0.310 | 850 | 15 | ○ | 60 | 90 | 0.031 | ○ | 990 | 2.5 | 65 | 35 | × | Comparative example |

In all of the examples of the present invention, it was confirmed that the bonded interface had high bonding strength, embrittlement of the clad material was suppressed, and excellent vibration power generation characteristics were obtained. On the other hand, in comparative examples outside the scope of the present invention, roll bonding could not be performed, or, even when the roll bonding could be performed, the bonding strength was not sufficient, embrittlement had progressed, or the vibration power generation characteristics were deteriorated.

Clad material No. 25 (comparative example) could not be bonded (bonding failure) since the surface hardness of the Ni material used as a raw material was as high as more than 140 HV, resulting in low adhesion strength during roll bonding. Further, clad material No. 26 could not be bonded (bonding failure) since the surface hardness of the Fe-Co-based alloy material used as a raw material was as high as more than 250 HV, resulting in low bonding strength during roll bonding. Further, clad material No. 27 could not be bonded (bonding failure) because the reduction ratio during roll bonding was as low as less than 45%. Further, clad material No. 28 fractured during the first cold rolling since the processing temperature during roll bonding exceeded 720°C, causing embrittlement due to ordering of the α' phase to progress. Further, clad material No. 29 could not achieve sufficient bonding strength, since the heating temperature of the diffusion heat treatment was below 730°C, making mutual diffusion difficult at the bonded interface. Further, clad material No. 30 could not achieve sufficient bonding strength, since the holding time of the diffusion heat treatment was less than 1 minute, making mutual diffusion difficult at the bonded interface. Further, for clad material No. 31, since the heating temperature in the finish heat treatment was below 730°C, stress in the Fe-Co-based alloy material could not be removed, resulting in a decrease in vibration power generation characteristics. Further, for clad material No. 32, since the holding time of the finish heat treatment was less than 2 hours, a mixed phase of the α' phase and the γ phase was formed after cooling, resulting in a decrease in vibration power generation characteristics. Further, for clad materials No. 33 and No. 34, since the thickness of the Fe-Co-based alloy layer after cold rolling falls outside the range of 40 to 60% of the total thickness of the clad material (cold-rolled clad material), cancellation of the magnetostrictive effect/inverse magnetostrictive effect of each of the Fe-Co-based alloy material and the Ni material occurs, resulting in a decrease in vibration power generation characteristics.

### Reference Signs List

- 1: Fe-Co-based alloy material
- 2: Ni material
- 3: roll
- 4: Ni layer
- 5: Fe-Co-based alloy layer
- 6: power generation coil
- 7: vibration source
- 8: permanent magnet
- 9: yoke
- 10: weight

## Claims

1. A method for producing a clad material for magnetostrictive vibration power generation having a two-layer clad structure, wherein
two types of metal strips, a Fe-Co-based alloy material having a hardness of 250 HV or less in surface hardness and a Ni material having a hardness of 140 HV or less in surface hardness, are used as raw materials, and the method comprising the following steps in the stated sequence:
a roll bonding step comprising stacking the two types of metal strips and performing a roll bonding treatment with a reduction ratio of 45 to 90% to obtain a clad material having a two-layer clad structure;
a diffusion heat treatment step of performing a diffusion heat treatment at a heating temperature of 730 to 1400°C;
a cold rolling step of performing cold rolling with a cumulative reduction ratio of 10 to 98%; and
a finish heat treatment step of performing a finish heat treatment at a heating temperature of 730 to 1000°C.

2. The method for producing a clad material for magnetostrictive vibration power generation according to claim 1, wherein the clad material after cold rolling is a cold-rolled metal strip having a sheet thickness of 0.03 to 2.0 mm.

3. The method for producing a clad material for magnetostrictive vibration power generation according to claim 2, wherein the clad material after cold rolling contains an Fe-Co-based alloy layer with a thickness of 40 to 60% of a total sheet thickness.

4. The method for producing a clad material for magnetostrictive vibration power generation according to claim 1, wherein the roll bonding treatment is performed in a processing temperature range of 20 to 720°C.

5. The method for producing a clad material for magnetostrictive vibration power generation according to claim 1, wherein the diffusion heat treatment has a holding time of 1 to 30 minutes, and the finish heat treatment has a holding time of 2 hours or more.

6. The method for producing a clad material for magnetostrictive vibration power generation according to claim 1, wherein the Fe-Co-based alloy material has a composition consisting of, in % by mass, Fe: 40 to 60% or further V: 1 to 5%, with a remainder of Co and inevitable impurities, and the Ni material has a composition consisting of, in % by mass, Ni: 99.5% or more, with a remainder of inevitable impurities.
